# EUROPÄISCHE PATENTSCHRIFT

(11) **EP 3 084 808 B1**
(45) Veröffentlichungstag und Bekanntmachung des Hinweises auf die Patenterteilung: **18.10.2017**
(21) Anmeldenummer: 14815336.4
(22) Anmeldetag: 17.12.2014
(51) Int. Cl.: H01L 21/285, H01L 29/45, H01S 5/042, H01S 5/22, H01L 29/20, H01L 33/40

(54) **VERFAHREN ZUM AUSBILDEN EINES METALLKONTAKTS AUF EINER OBERFLÄCHE EINES HALBLEITERS UND VORRICHTUNG MIT EINEM METALLKONTAKT**
FORMING A METAL CONTACT ON A SURFACE OF A SEMICONDUCTOR, AND DEVICE WITH A METAL CONTACT
PROCÉDÉ POUR FORMER UN CONTACT MÉTALLIQUE SUR UNE SURFACE D'UN SEMI-CONDUCTEUR ET DISPOSITIF ÉQUIPÉ D'UN CONTACT MÉTALLIQUE

(30) Priorität: 17.12.2013 DE 102013226270
(43) Veröffentlichungstag der Anmeldung: 26.10.2016
(73) Patentinhaber: Forschungsverbund Berlin E.V., 12489 Berlin (DE)
(72) Erfinder: EINFELDT, Sven, 12623 Berlin (DE); REDAELLI, Luca, 38100 Grenoble (FR); KNEISSL, Michael, 10435 Berlin (DE)
(74) Vertreter: Gulde & Partner
(86) Internationale Anmeldenummer: PCT/EP2014/078189
(87) Internationale Veröffentlichungsnummer: WO 2015/091626

(56) Entgegenhaltungen:
- DE-A1-102009 034 359

## Beschreibung

Die Erfindung betrifft ein Verfahren zum Ausbilden mindestens eines Metallkontakts auf einer Oberfläche eines Halbleiters und eine Vorrichtung mit mindestens einem Metallkontakt.

Halbleiter, beispielsweise aus GaN, Galliumnitrid, finden in unterschiedlichen technischen Gebieten Anwendung. Ein Beispiel ist die Verwendung von epitaktischen Halbleiterwafern für die Herstellung von Rippenwellenleitern für eine Laserdiode.

Für viele dieser Anwendungen werden Metallkontakte auf einer Oberfläche des Halbleiters benötigt. Widerstandswerte solcher Metallkontakte hängen dabei empfindlich von Verunreinigungen und/oder Kristallfehlern und/oder der Stöchiometrie der Halbleiteroberfläche zum Zeitpunkt der Aufbringung des jeweiligen Metallkontakts ab. Die Stöchiometrie der Halbleiteroberfläche kann sich insbesondere während des Prozessierens des Halbleiters ändern.

Um die Widerstandswerte der Metallkontakte davon unbeeinflusst zu lassen, wird eine Schicht aus dem jeweiligen Metall auf die Halbleiteroberfläche vor jedem anderen Prozessieren des Halbleiters abgeschieden und mittels einer Maske subtraktiv strukturiert. Bestehen die Metallkontakte aus edlem, chemisch sehr inertem Metall ist hierfür ein Trockenätzverfahren, zum Beispiel Sputterätzen, reaktives lonenätzen (RIE), induktiv gekoppeltes Plasmaätzen (ICP) oder chemisch unterstütztes lonenstrahlätzen (CAIBE) erforderlich.

Bei solchen Trockenätzverfahren lagert sich im Zuge der Redeposition ein Teil des abgetragenen Metalls wieder auf der Oberfläche und auf Oberfläche und Rändern der Maske ab. Nach Entfernen der Maske verbleibt das an den Rändern der Maske redeponierte Metall als eine Art Zaun zurück. Dieser Zaun ist nur schwer entfernbar und kann bei der Ablagerung weiterer Schichten die Entstehung von Hohlräumen bewirken, die ihrerseits durch Behinderung des Wärmetransports die Verlässlichkeit des den Halbleiter umfassenden Bauelements beinträchtigen können.

Die Entstehung der Zäune nach dem Stand der Technik ist beispielhaft in Figuren 1 bis 3 dargestellt. Figur 1 zeigt den unstrukturierten Halbleiter 10 aus GaN mit einer Metallschicht 20 aus Pd, Palladium, auf einer Oberfläche 11 des Halbleiters 10. Wie in Figur 2 zu sehen, wird eine Maske 30, beispielsweise eine Hartmaske aus SiNₓ, aufgebracht. Dann wird die Metallschicht 20 durch Sputterätzen beispielsweise mit Argon strukturiert. Anschließend wird unter Verwendung derselben Maske der Halbleiter 10 mittels Plasmaätzen, zum Beispiel mit Chlor, strukturiert. Anschließend werden Reste der Maske entfernt. Es verbleibt die in Figur 3 dargestellte Struktur mit Ablagerungen 21, die seitlich an die Maske abgelagert wurden und nach Entfernen der Maske über die strukturierte Metallschicht 20' nach oben hinausragen.

Das Entfernen der Maske erfolgt zum Beispiel nasschemisch unter Verwendung von Flusssäure.

Ein Verfahren zur Bildung einer strukturierten Wolframschicht mittels einer Titanmaske ist in US 5,176,792 beschrieben. EP 0 889 519 A2 befasst sich mit einer Elektrodenstruktur für einen Kondensator. Eine Platinelektrode wird mittels einer Ti-Al-N-Hartmaske geätzt, wobei es zur Bildung transienter Seitenwandzäune infolge der Redisposition von Platin während des Ätzens kommt. US 6,433,436 B1 stellt die Herstellung einer multi-level-interconnect-Struktur in einem kombinierten Ätzprozess in einem Schritt dar. DE 10 2009 034 359 A1 betrifft einen Palladium basierten p-Kontakt für eine Leuchtdiode, speziell eine Nanopixel-LED auf GaN-Basis.

Der vorliegenden Erfindung liegt die Aufgabe zugrunde, ein Verfahren anzugeben, mit dem sich ein verlässlich funktionierender Metallkontakt auf einer Oberfläche eines Halbleiters bilden lässt.

Diese Aufgabe wird durch das Verfahren gemäß Anspruch 1 gelöst. Das Verfahren dient zum Ausbilden von mindestens einem Metallkontakt auf einer Oberfläche eines aus Galliumnitrid bestehenden Halbleiters und umfasst die Schritte: Aufbringen einer Metallschicht aus Palladium auf die Halbleiteroberfläche, Aufbringen einer Maske auf die Metallschicht, und Strukturieren zumindest der Metallschicht unter Verwendung der Maske, wobei durch das Strukturieren laterale Ablagerungen des Metalls der Metallschicht an der Maske entstehen, so dass die Maske nach dem Strukturieren eingebettet ist zwischen den Ablagerungen und der strukturierten Metallschicht. Das Verfahren ist dadurch gekennzeichnet, dass die Maske eine leitfähige Hartmaske ist, wobei das Strukturieren auch den Halbleiter strukturiert und folgende Schritte umfasst: Sputterätzen des Metalls mit Argon und Plasmaätzen des Halbleiters mit Chlor.

Da die Maske leitfähig ist, kann sie als verlorene Maske dienen und ein Abtragen der Maske und lateralen Ablagerungen erübrigt sich, so dass kein Oberflächenabschnitt des Metallkontakts konkav ist. Ablagerungen und verlorene Maske bilden einen Teil des Kontakts.

In einer vorteilhaften Ausführungsform umfasst die Maske mindestens ein zum Metall unterschiedliches, leitfähiges Material. Dann kann das unterschiedliche Material eine unterste Schicht der Hartmaske bilden. Weiterhin umfasst die Hartmaske der besagten vorteilhaften Ausführungsform eine auf dem unterschiedlichen Material angeordnete Schicht aus dem Metall.

Im Ergebnis des Strukturierens umschließt das Metall das unterschiedliche Material, so dass die Leitfähigkeit des Kontakts durch die Anwesenheit des Materials im Kontakt nur minimal beeinflusst ist.

Das leitfähige Material kann zum Beispiel Titan, Nickel oder Chrom umfassen.

Der Halbleiter kann ein epitaktischer Halbleiter sein. Der Metallkontakt kann Teil eines Rippenwellenleiters sein. Der Metallkontakt kann auch eine Mesastruktur auf einer p-Seite einer Mikropixel-LED oder einer Nanopixel-LED sein.

Erfindungsgemäß wird weiterhin eine Vorrichtung gemäß Anspruch 7 vorgeschlagen mit mindestens einem Metallkontakt auf einer Oberfläche eines strukturierten Galliumnitrid-Halbleiters. Die Vorrichtung ist dadurch gekennzeichnet, dass der Metallkontakt ein leitfähiges Hartmaskenmaterial auf einer entsprechend strukturierten Palladiumschicht und zwischen Palladium-Ablagerungen umfasst, wobei alle Oberflächenabschnitte des Metallkontakts konvex oder eben sind. Das heißt, dass kein Oberflächenabschnitt des Metallkontakts konkav ist.

Die Erfindung wird nachfolgend in Ausführungsbeispielen anhand der zugehörigen Zeichnung erläutert. Es zeigen:

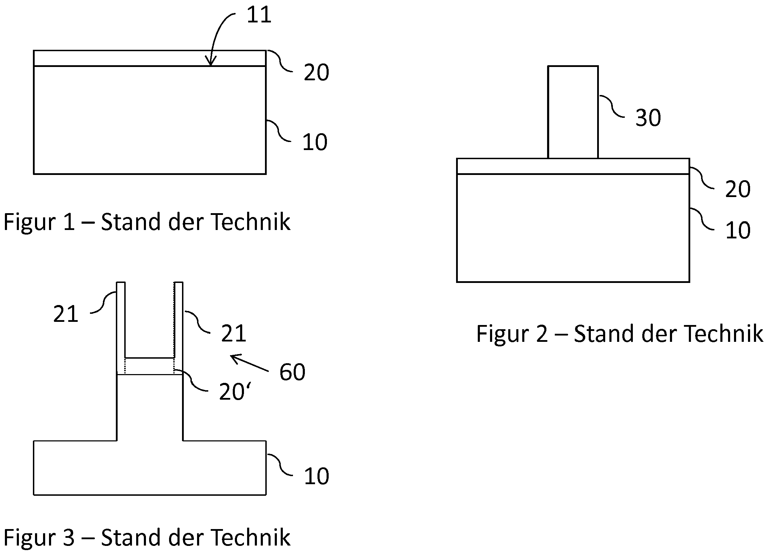

- Figuren 1, 2 und 3: schematisch unterschiedliche Zustände eines Halbleiters während eines Verfahrens nach Stand der Technik zur Ausbildung eines Metallkontakts, und

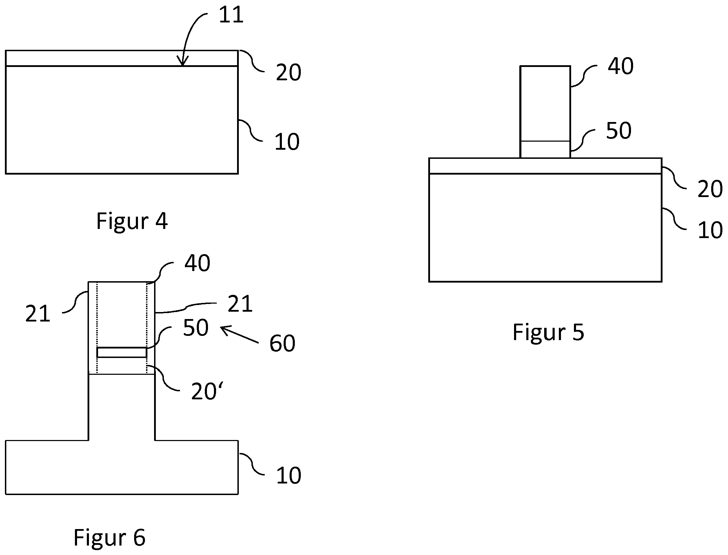

- Figuren 4, 5 und 6: schematisch unterschiedliche Zustände eines Halbleiters während eines Verfahrens gemäß einem Ausführungsbeispiel der Erfindung zur Ausbildung eines Metallkontakts.

Figur 4 zeigt den unstrukturierten Halbleiter 10 aus GaN mit einer Metallschicht 20 aus Pd, Palladium, auf einer Oberfläche 11 des Halbleiters 10. Der unstrukturierte Halbleiter 10 des Beispiels ist ein epitaktischer Halbleiter, die vorliegende Erfindung entfaltet ihren technischen Effekt aber auch für andere Halbleiter und ist nicht auf epitaktische Halbleiter beschränkt. Wie in Figur 5 zu sehen, wird eine leitfähige Hartmaske 40, 50 aufgebracht, die eine unterste Schicht 50 aus Ti, Titan, umfasst. Andere leitfähige Materialien, die zu Palladium unterschiedlich sind, sind Ni, Nickel, und Cr, Chrom. Eine oberste Schicht 40, die auf der untersten Schicht 50 angeordnet ist, besteht auch aus Palladium. Die oberste Schicht 40 ist optional und im Beispiel deutlich dicker als die Metallschicht 20. Im Beispiel sind nur zwei Schichten vorhanden, so dass die oberste Schicht 40 direkt auf der untersten Schicht 50 angeordnet ist. Es sind aber im Sinne der Erfindung noch weitere leitfähige Zwischenschichten möglich. Wird nur eine einzige Schicht verwendet, ist es umso vorteilhafter, je ähnlicher die elektrischen Eigenschaften des unterschiedlichen leitfähigen Materials zu denen des Metalls sind. Insbesondere kann die Hartmaske auch aus dem Metall der Metallschicht 20 bestehen.

Dann wird die Metallschicht 20 durch Sputterätzen beispielsweise mit Argon strukturiert, also im nicht maskierten Bereich abgetragen. Dabei wird die oberste Schicht 40 entsprechend abgetragen, da diese aber dicker ist als die Metallschicht 20, verbleibt von der obersten Schicht 40 ein Rest, wenn die Metallschicht 20 in dem nicht maskierten Bereich bereits vollständig abgetragen ist.

Das in dem nicht maskierten Bereich und von der Oberfläche der obersten Schicht 40 abgetragene Metall lagert sich lateral als Ablagerungen 21 aus dem Metall an die strukturierte Metallschicht 20' und an die Schichten 40 und 50 der Maske an.

Anschließend wird unter Verwendung derselben Maske der Halbleiter 10 mittels Plasmaätzen, zum Beispiel mit Chlor, strukturiert.

Wie in Figur 6 zu sehen ist, umschließen die Ablagerungen 21 und die Schichten 20' und 50 das unterschiedliche, leitfähige Material der Schicht 40. Die Reste der Hartmaske, also die Reste der Schicht 50 und die Schicht 40, sind alle leitfähig und können als Teil des Kontakts genutzt werden, so dass weder die Maske, noch die Ablagerungen entfernt werden müssen. Daher wird kein Oberflächenabschnitt des Metallkontakts erzeugt, der konkav ist. Das erfindungsgemäß vorgestellte Verfahren erfordert zudem weniger Verfahrensschritte. Der Kontakt ist über die Oberfläche des Rests der Schicht 40 gut kontaktierbar und der Hohlraum zwischen den Ablagerungen 21 ist verfüllt, so dass keine Entfernung der Ablagerungen 21 notwendig ist. Die erfindungsgemäß vorgestellte Vorrichtung hat also verlässlichere und bessere Funktionalität.

Metallkontakte im Sinne der Erfindung können in vielfältigen Anwendungen vorteilhaft verwendet werden. Beispielsweise kann der Metallkontakt Teil eines Rippenwellenleiters sein. Es ist zum Beispiel auch möglich, dass der Metallkontakt eine Mesastruktur auf einer p-Seite einer Mikropixel-LED oder einer Nanopixel-LED ist.

In einer beispielhaften Ausführungsform umfasst der Metallkontakt ein leitfähiges Hartmaskenmaterial auf einer entsprechend strukturierten Palladiumschicht und zwischen Palladium-Ablagerungen, wobei alle Oberflächenabschnitte des Metallkontakts konvex oder eben sind. Das heißt, dass in dieser beispielhaften Ausführungsform kein Oberflächenabschnitt des Metallkontakts konkav ist.

## Patentansprüche

1. Verfahren zum Ausbilden von mindestens einem Metallkontakt (60) auf einer Oberfläche (11) eines aus Galliumnitrid bestehenden Halbleiters (10), umfassend die Schritte:
• Aufbringen einer Metallschicht (20) aus Palladium auf die Halbleiteroberfläche (11),
• Aufbringen einer Maske (40, 50) auf die Metallschicht (20), und
• Strukturieren zumindest der Metallschicht (20) unter Verwendung der Maske (40, 50) wobei durch das Strukturieren laterale Ablagerungen (21) des Metalls der Metallschicht an der Maske entstehen, so dass die Maske nach dem Strukturieren eingebettet ist zwischen den Ablagerungen (21) und der strukturierten Metallschicht (20'),
**gekennzeichnet dadurch, dass**
die Maske eine leitfähige Hartmaske ist, wobei das Strukturieren auch den Halbleiter (10) strukturiert und folgende Schritte umfasst: Sputterätzen des Metalls (20) mit Argon und Plasmaätzen des Halbleiters (10) mit Chlor.

2. Verfahren nach Anspruch 1, wobei die Maske mindestens ein zum Metall unterschiedliches, leitfähiges Material (40) umfasst und wobei das unterschiedliche Material (40) eine unterste Schicht der Hartmaske bildet und die Hartmaske weiterhin eine auf dem unterschiedlichen Material (40) angeordnete Schicht (50) aus dem Metall umfasst.

3. Verfahren nach Anspruch 2, wobei das leitfähige Material (40) Titan, Nickel oder Chrom umfasst.

4. Verfahren nach einem der vorangehenden Ansprüche, wobei der Halbleiter (10) epitaktisch ist.

5. Verfahren nach einem der vorangehenden Ansprüche, wobei der Metallkontakt (60) Teil eines Rippenwellenleiters ist.

6. Verfahren nach einem der vorangehenden Ansprüche, wobei der Metallkontakt (60) eine Mesastruktur auf einer p-Seite einer Mikropixel-LED oder einer Nanopixel-LED ist.

7. Vorrichtung mit mindestens einem Metallkontakt (60) auf einer Oberfläche (11) eines strukturierten Galliumnitrid-Halbleiters (10), wobei der Metallkontakt ein leitfähiges Hartmaskenmaterial auf einer entsprechend strukturierten Palladiumschicht (20') und zwischen Palladium-Ablagerungen (21) umfasst, wobei kein Oberflächenabschnitt des Metallkontakts (60) konkav ist.

8. Vorrichtung nach Anspruch 7, wobei alle Oberflächenabschnitte eben sind.

## Claims

1. A method for forming at least one metal contact (60) on a surface (11) of a semiconductor (10) made of gallium nitride, comprising the steps of:
• applying a metal layer (20) of palladium onto the semiconductor surface (11),
• applying a mask (40, 50) onto the metal layer (20), and
• structuring at least the metal layer (20) using the mask (40, 50), wherein lateral deposits (21) of the metal of the metal layer are produced on the mask by the structuring so that the mask is embedded between the deposits (21) and the structured metal layer (20') after the structuring, **characterized in that**
the mask is a conductive hard mask, wherein the structuring also structures the semiconductor (10) and comprises the following steps: sputter etching the metal (20) with argon and plasma etching the semiconductor (10) with chlorine.

2. The method according to claim 1, wherein the mask includes at least one conductive material (40) different from the metal, and wherein the different material (40) forms a lowermost layer of the hard mask and the hard mask further includes a layer (50) made of the metal which is arranged on the different material (40).

3. The method according to claim 2, wherein the conductive material (40) includes titanium, nickel or chromium.

4. The method according to any one of the preceding claims, wherein the semiconductor (10) is epitaxial.

5. The method according to any of the preceding claims, wherein the metal contact (60) is a part of a ridge waveguide.

6. The method according to any of the preceding claims, wherein the metal contact (60) is a mesa structure on a p-side of a micro-pixel LED or a nanopixel LED.

7. A device with at least one metal contact (60) on a surface (11) of a structured gallium nitride semiconductor (10), wherein the metal contact comprises a conductive hard mask material on a correspondingly structured palladium layer (20') and between palladium deposits (21), wherein no surface section of the metal contact (60) is concave.

8. The device according to claim 7, wherein all surface sections are flat.

## Revendications

1. Procédé pour former au moins un contact métallique (60) sur une surface (11) d'un semi-conducteur (10) fait de nitrure de gallium, comprenant les étapes suivantes :
• appliquer une couche métallique (20) de palladium sur la surface (11) du semi-conducteur,
• appliquer un masque (40, 50) sur la couche métallique (20), et
• structurer au moins la couche métallique (20) en utilisant le masque (40, 50), des dépôts latéraux (21) du métal de la couche métallique étant produits sur le masque par la structuration, de sorte qu'après la structuration, le masque est encastré entre les dépôts (21) et la couche métallique (20') structurée,
**caractérisé en ce que**
le masque est un masque dur conducteur, la structuration structurant également le semi-conducteur (10) et comprenant les étapes suivantes : gravure par pulvérisation cathodique du métal (20) en utilisant de l'argon et gravure au plasma du semi-conducteur (10) en utilisant du chlore.

2. Procédé selon la revendication 1, dans lequel le masque comprend au moins un matériau (40) conducteur différent du métal, et dans lequel le matériau (40) différent forme une couche la plus basse du masque dur, et le masque dur comprend en outre une couche (50) faite dudit métal disposée sur le matériau (40) différent.

3. Procédé selon la revendication 2, dans lequel le matériau (40) conducteur comprend du titane, du nickel, ou du chrome.

4. Procédé selon l'une des revendications précédentes, dans lequel le semi-conducteur (10) est épitaxial.

5. Procédé selon l'une des revendications précédentes, dans lequel le contact métallique (60) fait partie d'un guide d'ondes nervuré.

6. Procédé selon l'une des revendications précédentes, dans lequel le contact métallique (60) est une structure mésa sur un côté de type p d'une DEL de micropixel ou d'une DEL de nanopixel.

7. Dispositif équipé d'au moins un contact métallique (60) sur une surface (11) d'un semi-conducteur (10) de nitrure de gallium structuré, le contact métallique comprenant un matériau de masque dur conducteur se trouvant sur une couche de palladium (20') structurée de manière correspondante et entre des dépôts de palladium (21), aucune portion de surface du contact métallique (60) n'étant concave.

8. Dispositif selon la revendication 7, dans lequel toutes les portions de surface sont planes.
